(19) Europäisches Patentamt
European Patent Office
Office européen des brevets

(11) **EP 2 149 987 B1**

(12) **FASCICULE DE BREVET EUROPEEN**

(45) Date de publication et mention
de la délivrance du brevet:
**18.06.2014 Bulletin 2014/25**

(51) Int Cl.:
***H03H 11/00*** *(2006.01)*

(21) Numéro de dépôt: **09305616.6**

(22) Date de dépôt: **29.06.2009**

(54) **Procédé et dispositif de filtrage anti-à-coups pour véhicule automobile**

Filterungsverfahren und Einrichtung zur Vermeidung von Ruckbewegungen für Kraftfahrzeuge

Filtering method and system for avoiding jolts in vehicles

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **27.07.2008 FR 0804269**

(43) Date de publication de la demande:
**03.02.2010 Bulletin 2010/05**

(73) Titulaire: **Renault s.a.s.**
**92100 Boulogne Billancourt (FR)**

(72) Inventeurs:
• **Cordesses, Lionel**
**78180 Montigny le Bretonneux (FR)**
• **Marsilia, Marco**
**92100 Boulogne Billancourt (FR)**
• **Ferreira de Araujo, Manoela**
**94230 Cachan (FR)**

(56) Documents cités:
**EP-A- 0 208 328     US-A- 4 975 650**
**US-A- 4 980 653**

• **ASHOK SWAMINATHAN ET AL: "A Wide-Bandwidth 2.4 GHz ISM Band FractionalPLL With Adaptive Phase Noise Cancellation" IEEE JOURNAL OF SOLID-STATE CIRCUITS, IEEE SERVICE CENTER, PISCATAWAY, NJ, US, vol. 42, no. 12, 1 décembre 2007 (2007-12-01), pages 2639-2650, XP011197064 ISSN: 0018-9200**

**Description**

L'invention concerne un procédé et un dispositif de filtrage d'une grandeur d'un système embarqué dans un véhicule automobile, par exemple sur la base de la correction d'une commande du moteur, comme une donnée directement liée à la pédale d'accélérateur d'un véhicule automobile. Ainsi, l'invention concerne aussi un procédé et un dispositif d'atténuation des à-coups ressentis par la caisse d'un véhicule automobile équipé d'un moteur à combustion interne pouvant survenir lors de conditions particulières de fonctionnement du véhicule. Elle concerne aussi un véhicule automobile en tant que tel mettant en oeuvre un tel procédé.

En effet, dans certaines conditions de fonctionnement d'un véhicule automobile équipé d'un moteur à combustion interne, notamment en régimes transitoires suite à un enfoncement plus ou moins brutal de la pédale d'accélérateur, des phénomènes d'oscillations du couple transmis aux roues du véhicule apparaissent, appelés à-coups, et affectent le confort des passagers du véhicule.

Ces à-coups ont pour principale origine la chaîne cinématique reliant le moteur à l'interface pneu/sol. En effet, l'énergie mécanique en bout de vilebrequin est transmise aux roues par un système de transmission comprenant traditionnellement un embrayage, une boîte de vitesses et un différentiel. Chacun de ces éléments possède un amortissement et une rigidité propre : des commandes brusques au niveau de la pédale d'accélérateur sont donc transmises par cette chaîne mécanique et se répercutent parfois au niveau des roues sous la forme d'à-coups.

Pour pallier à ces inconvénients, il existe des solutions à base de logiciel de contrôle en boucle ouverte ou en boucle fermée avec cartographies de l'ensemble du système pour réduire les phénomènes d'à-coups. Plus précisément, deux familles de solutions existent. La première famille consiste en la mise en oeuvre d'une régulation par contre-réaction d'une estimation du jerk moteur. La seconde famille repose sur le filtrage de la consigne de couple. Toutes ces solutions reposent sur des régulations linéaires et effectuent une atténuation des à-coups qui reste la même dans toutes les circonstances, notamment pendant les phases d'enfoncement et de relâchement de la pédale d'accélérateur. Ces solutions simplifiées donnent des résultats globalement insatisfaisants et nécessitent une mise au point. Les mêmes remarques s'appliquent à d'autres situations et d'autres paramètres d'un véhicule automobile nécessitant de même une régulation.

Un objet de la présente invention est donc de proposer un procédé et un dispositif de régulation qui améliorent les solutions existantes et notamment applicable à l'atténuation des à-coups d'un véhicule automobile.

Le concept de l'invention repose sur une approche non linéaire de la régulation. Ainsi, pour l'application à l'atténuation des à-coups, l'invention repose sur la distinction entre une première situation correspondant à un enfoncement de la pédale d'accélération et une seconde situation correspondant à un relâchement de cette pédale, puisque les à-coups sont plus violents dans cette seconde situation. Ensuite, pour chacune de ces deux situations, l'atténuation apportée par l'invention est différente, plus forte dans la seconde situation.

Ainsi, l'invention repose sur un dispositif de filtrage pour atténuer les variations d'un paramètre d'un système appartenant à un véhicule automobile, **caractérisé en ce qu**'il comprend un filtrage non linéaire comprenant au moins deux éléments non linéaires (NL1), (NL2) qui permettent de faire changer la bande passante du filtre selon que le signal d'entrée monte ou descend, le filtre pouvant se représenter dans les deux cas par un filtrage du second ordre basé sur la fonction de transfert H'(s) suivante,

$$H'(s) = \frac{1}{1 + 2\frac{\xi}{\omega_0}s + \frac{s^2}{\omega_0^2}}$$

H'(s) peut aussi s'écrire de la façon suivante :

$$H'(s) = \frac{L(s)}{1 + L(s)}$$

avec

$$L(s) = \left( 2 \frac{\xi}{\omega_0} s + \frac{s^2}{\omega_0^2} \right)^{-1}$$

Soit L(s) réécrit dans la forme suivante :

$$L(s) = K \cdot \frac{1}{s} \cdot \left( \frac{1}{1 + \tau s} \right) \quad \text{avec} \quad K = \frac{\omega_0}{2\xi} \quad \text{et} \quad \tau = \frac{1}{2\xi\omega_0}$$

Le dispositif de filtrage peut comprendre au moins un premier élément non linéaire (NL1) disposé en entrée du dispositif et permettant de transformer un signal entrant (e) en une grandeur déterminée par la formule e+K1*NL1(e) où K1 représente un gain, et peut comprend au moins un second élément non linéaire (NL2) disposé sur une boucle de retour du dispositif.

Le dispositif de filtrage peut comprendre deux éléments non linéaires (NL1, NL2), des gains (K1 à K5), deux intégrateurs, un dérivateur, des additionneurs et des soustracteurs, le dispositif comprenant une voie principale sur laquelle sont disposés en aval du premier élément non linéaire (NL1) un additionneur, un premier soustracteur sur lequel arrive par une première voie de retour la grandeur définie par la formule y + K5 * NL2(y), un gain (K2), un second soustracteur sur lequel arrive par une seconde voie de retour la grandeur définie par la formule y/G + K4*G'(s)*NL2(y), un gain (K3), deux intégrateurs, y représentant la grandeur de sortie du dispositif de filtrage et G la fonction de transfert du second intégrateur.

Les deux éléments non linéaires peuvent se comporter selon le système d'équations suivant :

$$\begin{cases} NL1(x) = NL2(x) = x & si \quad x > 0 \\ NL1(x) = NL2(x) = 0 & si \quad x \le 0 \end{cases}$$

La fréquence de coupure ($\omega_0$) du filtre peut être modifié d'un facteur A de sorte à prendre une valeur différente (A $\omega_0$) sans changer l'amortissement ($\xi$) entre les configurations de montée ou de descente de la valeur d'entrée (e), en choisissant les paramètres de gain suivants :

$$K1 = A^2 - 1$$

$$K2 = K$$

$$K3 = 1/\tau$$

$$K4 = A - 1$$

$$K5 = A^2 - 1$$

$$\text{Où} \quad K = \frac{\omega_0}{2\xi} \quad \text{et} \quad \tau = \frac{1}{2\xi\omega_0}$$

Le dispositif de filtrage peut comprendre une première série d'éléments non linéaires montés en parallèle (NL1,...NLj) en entrée du dispositif, et dont les résultats sont additionnés, et peut comprendre une seconde série d'éléments non linéaires montés en parallèle (NLj+1,...NLn) disposés sur une boucle de retour du dispositif, et dont les résultats sont additionnés, le dispositif modifiant la bande passante du filtrage en fonction du sens de variation du signal d'entrée et en fonction de l'amplitude du signal d'entrée (e) ou de sa dérivée.

Le dispositif de filtrage peut être analogique, comprendre des composants électroniques et les au moins deux éléments non linéaires peuvent comprendre une diode.

En variante, le dispositif de filtrage peut être numérique et la variation de la fréquence de coupure du filtre peut être obtenue par une variation de la fréquence d'échantillonnage.

L'invention porte aussi sur un dispositif d'atténuation des à-coups d'un véhicule automobile **caractérisé en ce qu'**il comprend un dispositif de filtrage tel que défini précédemment.

L'invention porte aussi sur un véhicule automobile comprenant un dispositif de filtrage tel que défini précédemment.

L'invention porte aussi sur un procédé d'atténuation des à-coups d'un véhicule automobile **caractérisé en ce qu'**il comprend les étapes suivantes :

- détection de l'enfoncement ou du relâchement de la pédale d'accélération ;
- réalisation d'une première correction d'au moins un paramètre de commande du moteur du véhicule automobile lors d'un enfoncement de la pédale d'accélération ;
- réalisation d'une seconde correction du au moins un paramètre de commande du moteur du véhicule automobile lors d'un relâchement de la pédale d'accélération, cette seconde correction étant différente de la première correction,

ces deux corrections étant réalisées par un dispositif de filtrage tel que défini précédemment.

La seconde correction du au moins un paramètre de commande du moteur du véhicule automobile lors d'un relâchement de la pédale d'accélération peut représenter une atténuation plus forte des à-coups que dans le cas de la première correction en situation d'enfoncement de la pédale d'accélération.

Les deux corrections peuvent comprendre un filtrage non linéaire d'au moins un paramètre de commande du moteur du véhicule automobile.

La modification du filtrage entre l'enfoncement et le relâchement de la pédale d'accélération peut comprendre la modification de la fréquence de coupure du filtre sans changer l'amortissement.

Le paramètre de commande du moteur corrigé peut correspondre directement ou indirectement à la position de la pédale d'accélération.

Ces objets, caractéristiques et avantages de la présente invention seront exposés en détail dans la description suivante d'un mode d'exécution particulier fait à titre non-limitatif en relation avec les figures jointes parmi lesquelles :

La figure 1 représente un schéma de principe de l'atténuation selon le mode d'exécution de l'invention ;
la figure 2 représente un schéma simplifié d'un filtre linéaire du deuxième ordre ;
la figure 3 représente un schéma de principe détaillé d'un dispositif de filtrage selon le mode d'exécution de l'invention ;
la figure 4 illustre le comportement d'un système mettant en oeuvre le principe de l'invention ;
la figure 5 représente un schéma de principe généralisé du dispositif de filtrage selon le mode d'exécution de l'invention ;
la figure 6 représente une variante du schéma de principe précédent de l'atténuation selon le mode d'exécution de l'invention ;
la figure 7 représente la réalisation analogique d'un intégrateur pour l'implémentation du schéma de principe de l'invention de la figure 6 ;
la figure 8 représente la réalisation analogique d'un soustracteur pour l'implémentation du schéma de principe de l'invention de la figure 6 ;
la figure 9 représente la réalisation analogique d'un additionneur pour l'implémentation du schéma de principe de l'invention de la figure 6 ;
la figure 10 représente la réalisation analogique d'un dérivateur pour l'implémentation du schéma de principe de l'invention de la figure 6 ;
la figure 11 représente la réalisation analogique d'un élément non linéaire pour l'implémentation du schéma de principe de l'invention de la figure 6 ;
la figure 12 représente la réalisation analogique d'un autre élément non linéaire pour l'implémentation du schéma de principe de l'invention de la figure 6 ;
la figure 13 représente un exemple de signal fourni par la pédale d'accélération ;
la figure 14 représente le signal de réponse au signal illustré sur la figure 13 d'un système avec et sans solution anti à-coups selon l'invention.

L'invention va être illustrée à titre d'exemple dans le cadre d'une application d'un dispositif de filtrage à l'atténuation des à-coups subis par la caisse d'un véhicule automobile. Dans ce cas, elle repose sur un dispositif et un procédé d'atténuation, voire suppression, des à-coups subis par la caisse d'un véhicule automobile, qui met en oeuvre une atténuation différente dans les situations d'enfoncement et de relâchement de la pédale d'accélération du véhicule automobile.

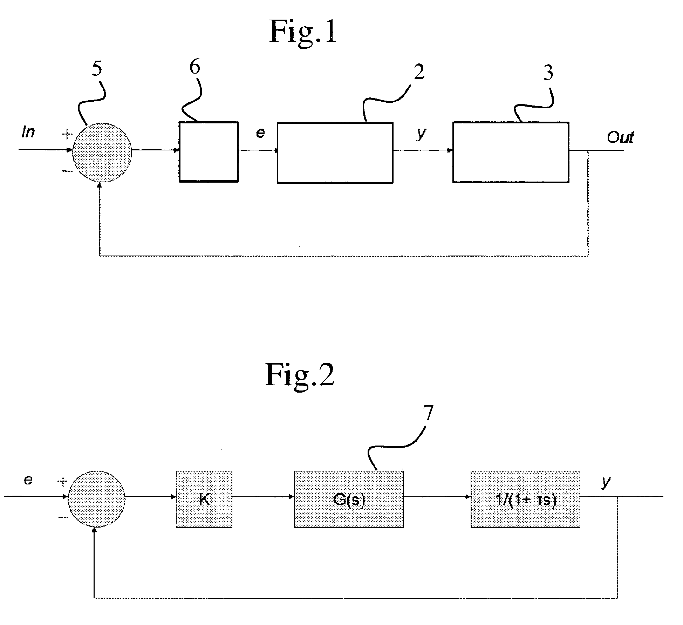

Les figures 1 à 6 représentent schématiquement le principe de fonctionnement du dispositif et procédé d'atténuation selon l'invention.

La figure 1 représente schématiquement le principe de suppression ou d'atténuation des à-coups selon l'invention. Ce dispositif repose sur le filtrage d'un paramètre de commande In en entrée du système pour obtenir un paramètre corrigé Out en sortie. Avantageusement, le dispositif repose sur un filtre passe-bas 2 non linéaire du deuxième ordre dont la fréquence de coupure change lors de l'enfoncement ou du relâchement de la pédale d'accélérateur. Ce filtre permet de transmettre en sortie une commande y corrigée, à partir d'une entrée e, cette commande y étant ensuite directement transmise au moteur 3. Ce principe repose de plus sur une boucle de retour en sortie du moteur 3 vers un additionneur 5 puis un gain 6 avant l'entrée dans le filtre 2.

Avantageusement, le procédé d'atténuation des à-coups repose sur le filtrage d'un paramètre de commande de rotation de l'arbre moteur, ce paramètre de commande étant déduit de la position de la pédale d'accélérateur ou représentant directement la position de cette pédale. Une telle approche présente l'avantage de s'attaquer directement à la source principale des à-coups de couple que sont les variations brutales de la pédale d'accélérateur qui engendrent classiquement des variations brutales correspondantes du débit d'air ou du débit de carburant et donc des variations brutales de couple. La consigne de couple du dispositif est ainsi corrigée. Le paramètre de commande corrigé en réponse aux oscillations du couple moteur peut par exemple être la position d'ouverture du papillon des gaz.

Avant de détailler le fonctionnement du filtre passe-bas 2 non linéaire du deuxième ordre, rappelons dans un premier temps le fonctionnement d'un filtre passe-bas linéaire du deuxième ordre. En notant s l'opérateur de Laplace et H'(s) sa fonction de transfert, on a :

$$H'(s) = \frac{1}{1 + 2\dfrac{\xi}{\omega_0}s + \dfrac{s^2}{\omega_0^2}}$$

H'(s) peut aussi s'écrire de la façon suivante :

$$H'(s) = \frac{L(s)}{1 + L(s)}$$

avec

$$L(s) = \left( 2\dfrac{\xi}{\omega_0}s + \dfrac{s^2}{\omega_0^2} \right)^{-1}$$

Soit L(s) réécrit dans la forme suivante :

$$L(s) = K \cdot \frac{1}{s} \cdot \left( \frac{1}{1 + \tau s} \right)$$

avec

$$K = \frac{\omega_0}{2\xi} \quad \text{et} \quad \tau = \frac{1}{2\xi\omega_0} ,$$

La structure de H'(s) peut alors être représentée par le schéma de la figure 2 où un intégrateur 7 exécute la fonction G(s) = 1/s.

Sur le schéma de la figure 1 ou 2, le signal e est obtenu par la différence entre le signal de commande entrant In et le signal sortant du système Out et représente l'erreur du dispositif commandé. Cette erreur e est toujours positive quand le signal d'entrée In augmente, soit en phase d'enfoncement de la pédale d'accélérateur, et négative quand il descend, soit en phase de relâchement de la pédale d'accélérateur. Après calcul dans le filtre passe-bas, le signal y de sortie conserve cette même propriété, d'être positif pendant l'enfoncement de la pédale d'accélération et négatif pendant son relâchement.

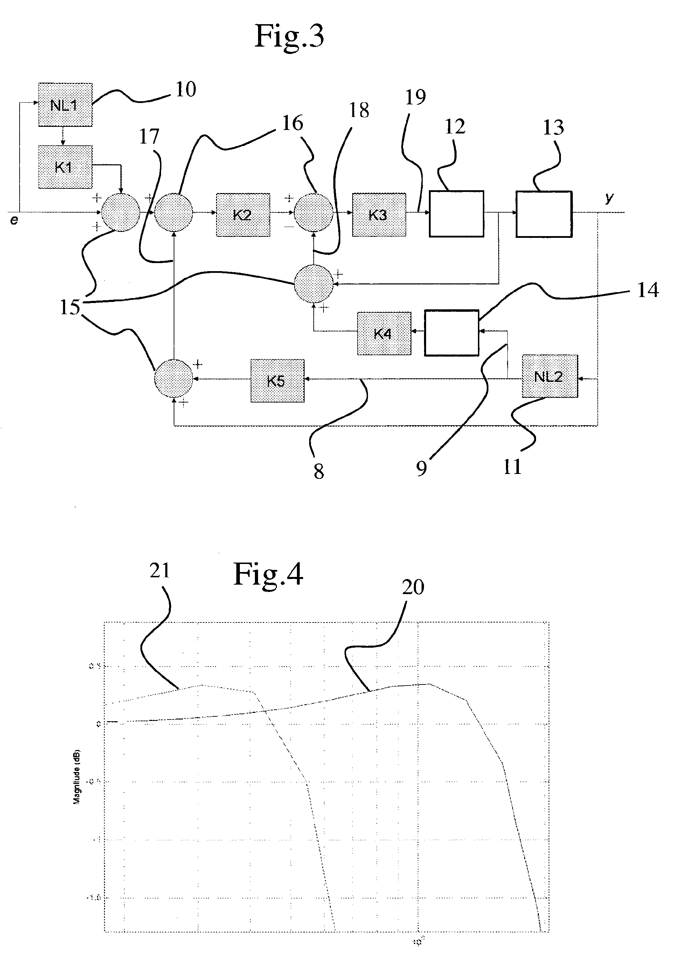

La figure 3 illustre le mode d'exécution de l'invention dans une version simplifiée dans laquelle le filtre passe-bas non linéaire 2 est dérivé des remarques précédentes. Il comprend deux éléments non linéaires (NL1) 10, (NL2) 11 qui permettent de faire changer la bande passante du filtre selon que le signal d'entrée monte ou descend, c'est-à-dire selon qu'un conducteur enfonce ou relâche la pédale d'accélérateur. Ce filtre comprend de plus des gains K1 à K5, deux intégrateurs 12, 13, un dérivateur 14, des additionneurs 15 et des soustracteurs 16.

Le premier élément non linéaire (NL1) est disposé en entrée du dispositif et permet de transformer un signal entrant e en e+K1*NL1(e).

Le second élément non linéaire (NL2) est disposé sur une boucle de retour du dispositif, permettant de renvoyer en entrée du dispositif une première valeur K5*NL2(y) par une première boucle de retour 8 et une seconde valeur K4*G'(s)*NL2(y) par une seconde boucle de retour 9, y étant la grandeur de sortie du dispositif. Ainsi, le dispositif reçoit en retour par une première voie 17 sur un premier soustracteur 16 une valeur y + K5 * NL2(y) * y et par une seconde voie 18 sur un second soustracteur 16 une valeur y/G + K4*G'(s)*NL2(y). Sur la voie principale 19 du dispositif se trouvent alignés un additionneur 15, un premier soustracteur 16 sur lequel arrive la première voie de retour 17, un gain K2, un second soustracteur 16 sur lequel arrive la seconde voie de retour 18, un gain K3, deux intégrateurs 12, 13.

Le fonctionnement des deux éléments non linéaires 10, 11 est défini par les équations suivantes :

$$\begin{cases} NL1(x) = NL2(x) = x & si \quad x > 0 \\ NL1(x) = NL2(x) = 0 & si \quad x \leq 0 \end{cases}$$

où les fonctions NL sont des fonctions non linéaires. Par exemple, elles peuvent présenter une non linéarité douce, c'est-à-dire dont la dérivée est non infinie, comme la fonction sigmoïde.

Avec un tel dispositif, la fréquence de coupure $\omega_0$ du filtre linéaire peut être modifié d'un facteur A (i.e. $\omega_0 \to A\,\omega_0$) sans changer l'amortissement $\xi$ en modifiant la valeur des paramètres K et de $1/_\tau$ du même facteur A. Pour cela, on choisit dans le système de la figure 3 les paramètres suivants :

$$K1 = A^2 - 1$$

$$K2 = K$$

$$K3 = 1/\tau$$

$$K4 = A - 1$$

$$K5 = A^2 - 1$$

Le système de la figure 3 avec les coefficients indiqués ci-dessus réalise donc un filtre passe bas non linéaire du second ordre dont la fréquence de coupure augmente d'un facteur A prédéfini lors de l'enfoncement de la pédale d'accélérateur.

La figure 4 montre un exemple de la réponse fréquentielle d'un tel filtre non linéaire. La courbe 20 représente la réponse pendant l'enfoncement de la pédale d'accélération et la courbe 21 lors du relâchement de la pédale. Ces courbes sont obtenues avec le facteur A de changement de la fréquence de coupure égal à 3. Elles montrent bien que la bande passante change d'un facteur A égal à 3 alors que le facteur d'amortissement de H(s) reste inchangé.

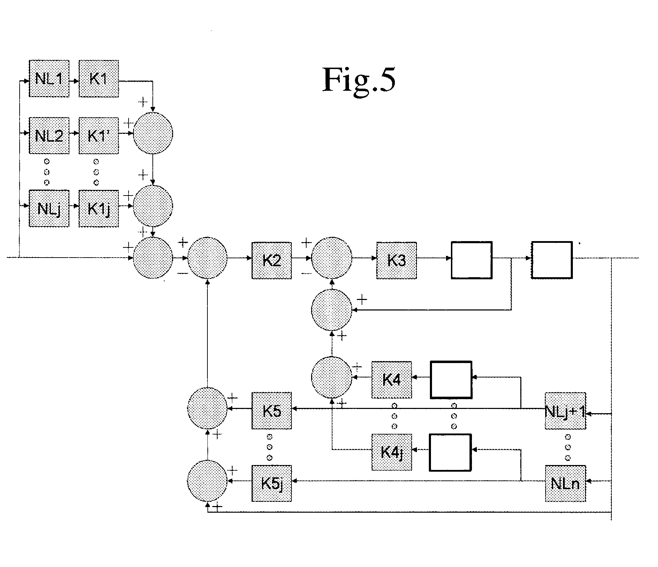

La figure 5 représente un schéma plus général de réalisation de l'invention, dans lequel un nombre n d'éléments non linéaires peuvent être utilisés. Comme cela est représenté, ce dispositif comprend une première série de j éléments non linéaires montés en parallèle du premier élément non linéaire NL1 de la réalisation de la figure 3, et dont les résultats sont additionnés. Ensuite, il comprend une seconde série de n-j éléments non linéaires montés en parallèle du second élément non linéaire NL2 de la réalisation de la figure 3, et dont les résultats sont additionnés. Cette solution permet à très faible surcoût, simplement en augmentant le nombre de ces éléments non linéaires, de faire varier la fréquence de coupure du système selon l'amplitude des oscillations du signal d'entrée. Cette solution généralisée permet donc de même de changer la bande passante en fonction du sens de variation du signal d'entrée, mais aussi en fonction de l'amplitude du signal d'entrée ou de sa dérivée.

Finalement, le procédé mis en oeuvre par l'invention peut se résumer par les étapes suivantes :

- détection de l'enfoncement ou du relâchement de la pédale d'accélération ;
- réalisation d'une première correction d'au moins un paramètre de commande du moteur du véhicule automobile lors d'un enfoncement de la pédale d'accélération ;
- réalisation d'une seconde correction du au moins un paramètre de commande du moteur du véhicule automobile lors d'un relâchement de la pédale d'accélération, cette seconde correction étant différente de la première correction.

Les deux corrections reposent sur un filtrage non linéaire d'au moins un paramètre de commande du moteur du véhicule automobile.

Le procédé précédent peut être mis en oeuvre par des dispositifs matériels et/ou logiciels.

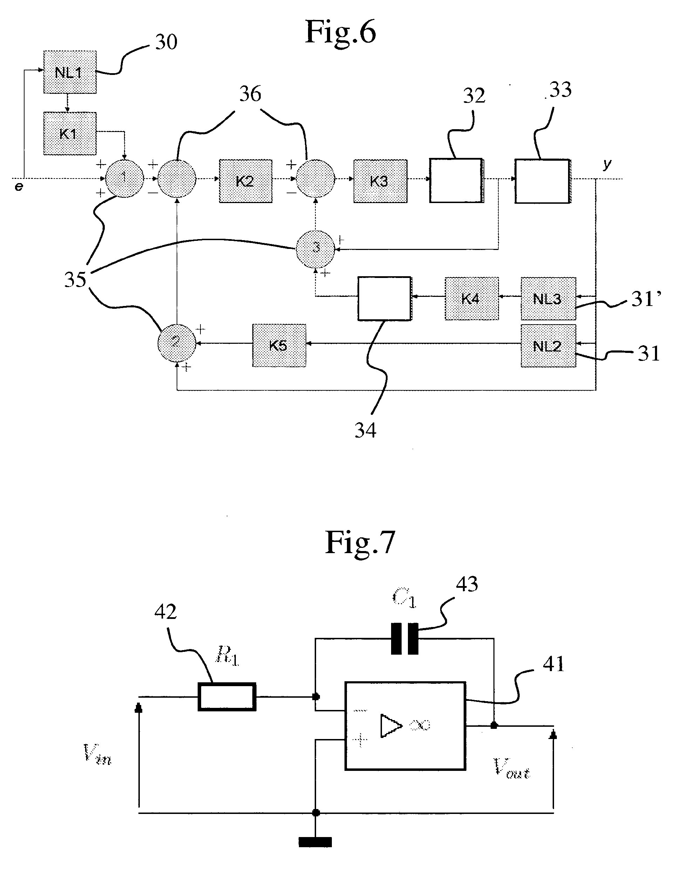

Les figures 7 à 12 représentent un mode d'exécution du dispositif d'atténuation à base d'électronique analogique, mettant en oeuvre le principe de l'invention représenté sur la figure 6, proche de celui de la figure 3. L'avantage d'un tel mode d'exécution est qu'il ne requiert pas de microprocesseur, ni de calcul numérique et est réalisable à très faible coût.

Le dispositif illustré sur la figure 6 comprend des intégrateurs 32, 33 qui peuvent être réalisés selon la réalisation analogique représentée sur la figure 7. Un tel intégrateur comprend un amplificateur opérationnel (AOP) 41, une résistance 42 de valeur R1 et une capacité 43 de valeur C1. En supposant l'AOP 41 idéal, la fonction de transfert de cet intégrateur entre la tension de sortie Vout et la tension en entrée Vin s'écrit de la manière suivante :

$$\frac{V_{out}}{V_{in}} = -\frac{1}{R_1 C_1 s}$$

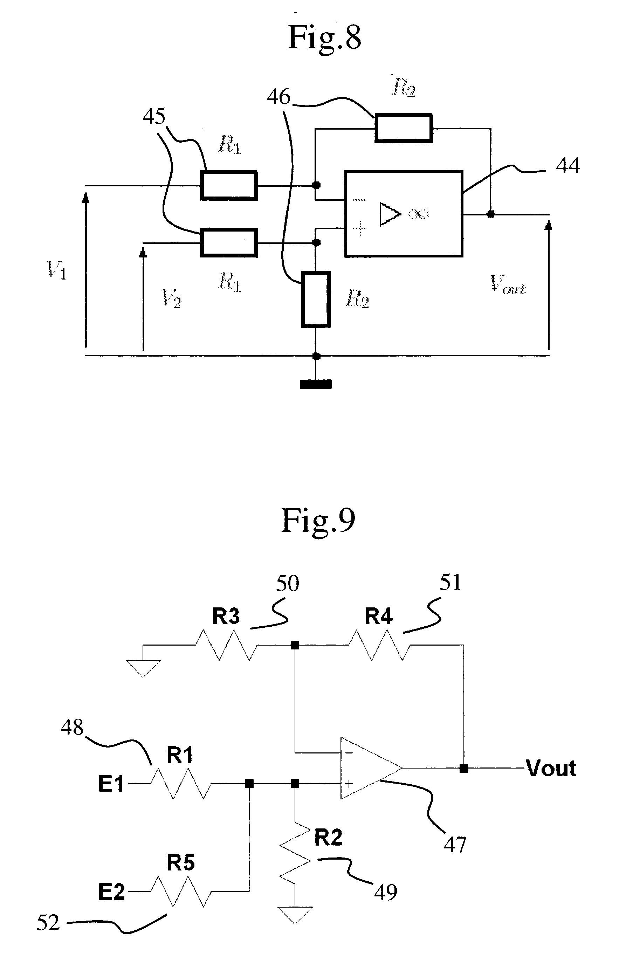

Le dispositif comprend de plus des éléments soustracteurs 36, qui incluent aussi les gains K2 et/ou K3 de la figure 6, qui peuvent être mis en oeuvre selon la structure analogique représentée en figure 8, sur la base d'un AOP 44, de deux résistances 45 de valeur R1 et de deux résistances 46 de valeur R2. Un tel élément soustracteur permet donc d'obtenir une tension de sortie Vout à partir de deux tensions d'entrée V1 et V2 selon la formule suivante :

$$V_{out} = \frac{R_2}{R_1}(V_2 - V_1)$$

En remarque, les éléments soustracteurs 36 de la figure 6 présentent des résistances de valeur différente.

Le dispositif comprend de plus des éléments additionneurs 35, qui peuvent aussi inclure des gains, par exemple K5, et qui peuvent être mis en oeuvre selon la structure représentée en figure 9, sur la base d'un AOP 47, de cinq résistances 48 à 52, de valeur R1 à R5. Un tel élément additionneur permet d'obtenir une tension de sortie Vout à partir de deux tensions E1 et E2 selon la formule suivante :

$$V_{out} = \frac{R2(R3+R4)}{R3(R1R2+R1R5+R2R5)}(E1R5+E2R1)$$

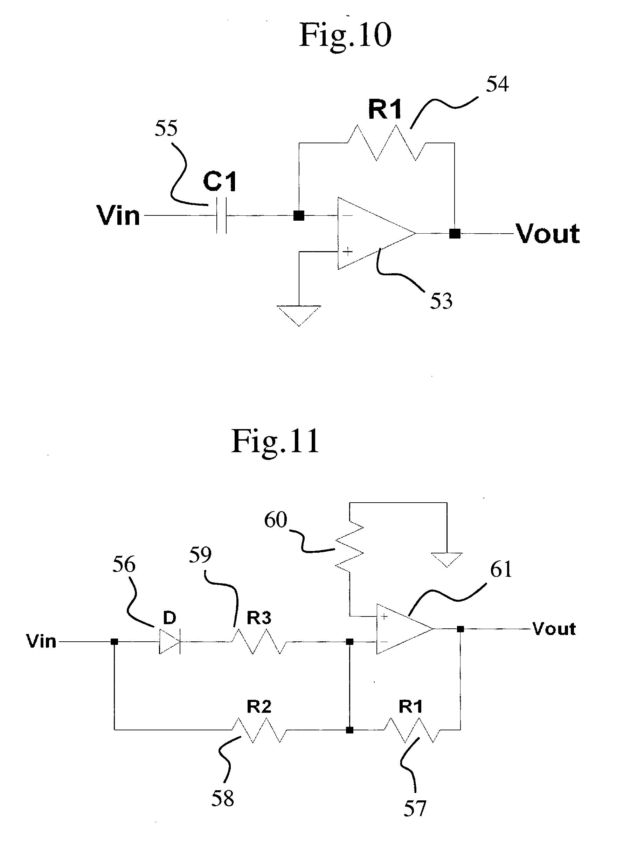

De plus, le dispositif comprend un dérivateur 34, qui peut être réalisé selon la réalisation représentée sur la figure 10. Il comprend un amplificateur opérationnel (AOP) 53, une résistance 54 de valeur R1 et une capacité 55 de valeur C1. La fonction de transfert de ce dérivateur entre la tension de sortie Vout et la tension en entrée Vin s'écrit de la manière suivante :

$$\frac{V_{out}}{V_{in}} = -sR_1C_1$$

Le dispositif comprend de plus des éléments non linéaires 30, 31, 31' qui peuvent aussi inclure des gains.

Par exemple, la réalisation selon la figure 11 permet la mise en oeuvre des éléments non linéaires 30, 31, associés respectivement aux gains K1 et K5. Cette réalisation repose sur une diode 56, quatre résistances 57 à 60 etunAOP61.

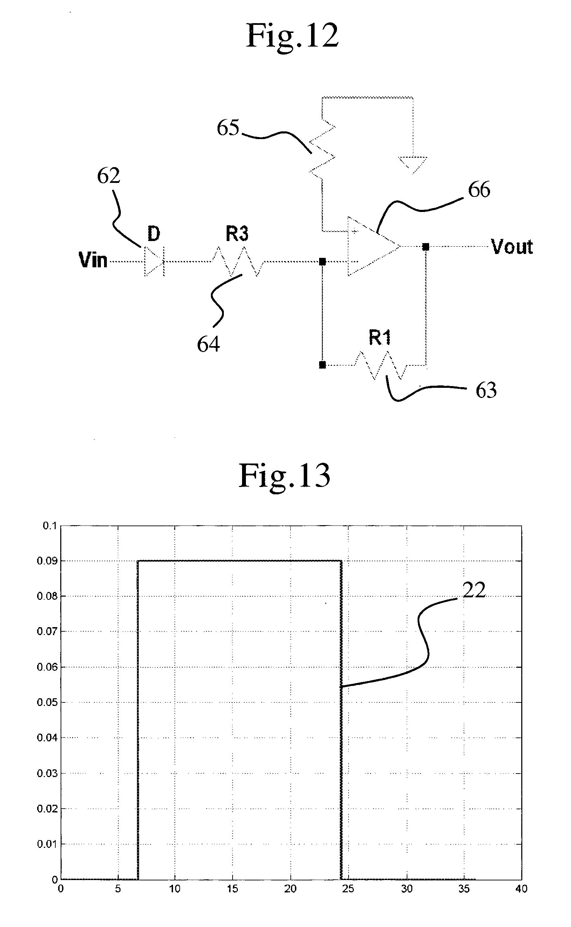

La figure 12 représente une autre réalisation qui peut correspondre à l'élément non linéaire 31' associé au gain K4. Elle comprend une diode 62, trois résistances 63 à 65 et un AOP 66.

Finalement, ces composants non linéaires permettent d'atteindre le comportement illustré par les équations suivantes :

$$\begin{cases} NL1(x) = NL2(x) = NL3(x) = x & si \quad x > 0 \\ NL1(x) = NL2(x) = NL3(x) = 0 & si \quad x \le 0 \end{cases}$$

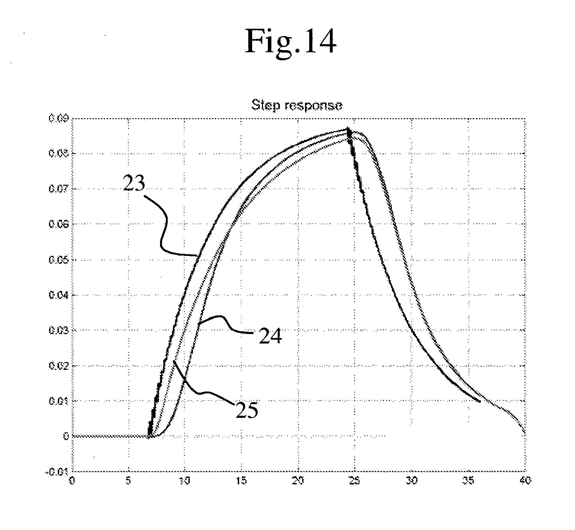

A titre d'illustration de l'effet technique atteint par l'invention, la figure 13 représente un exemple de signal de la pédale d'accélérateur, représenté par la courbe 22 consistant en une brusque accélération puis un brusque relâchement de la pédale. La figure 14 illustre les réponses de trois systèmes, représentées par les courbes 23, 24 et 25, correspondant respectivement à un système de motorisation sans solution anti à-coups, sur lequel on détecte de nombreuses zones avec des oscillations indésirables, un système avec un système d'anti à-coups linéaire se comportant de la même manière pour la phase d'enfoncement et de relâchement de la pédale d'accélération, et enfin un système d'atténuation des à-coups selon le mode d'exécution représenté en figure 3, dans lequel il apparaît que le comportement diffère dans chacune des deux phases. Pour ce mode d'exécution, l'amortissement a été choisi à une valeur de $\xi = 0.7$, la pulsation de coupure $\omega_0 = 2.5$ *rad/s* pendant la descente du signal d'entrée et le facteur A = 3, ce qui donne $\omega_0 = 7.5$ *rad/s* pendant la montée du signal d'entrée. Ainsi, le temps de réponse en descente est plus grand qu'en montée et les oscillations sont réduites davantage grâce à une bande passante plus petite dans la phase de relâchement de la pédale d'accélération.

L'invention a été avantageusement mise en oeuvre sur la base de la correction d'une commande du moteur, comme une donnée directement liée à la pédale d'accélérateur d'un véhicule automobile. Toutefois, le même principe pourrait être mis en oeuvre pour réguler tout autre paramètre du système.

L'implémentation décrite ci-dessus a été réalisée sur la base analogique avec des composants électroniques. Toutefois, une solution numérique est aussi possible. Dans ce cadre, un autre mode d'exécution consiste à obtenir une variation de la fréquence de coupure par une variation de la fréquence d'échantillonnage du système. En variante, la fréquence d'échantillonnage peut être constante et les intégrateurs 12, 13 de la figure 3 peuvent être réalisés sous forme numérique échantillonnée. Un exemple de réalisation pour un intégrateur d'entrée e et de sortie y est donné par la formule suivante :

$$y(k+1)=y(k)+Te*e(k)$$

où *k* représente l'indice de l'échantillon courant et Te la période d'échantillonnage en secondes, choisie pour respecter le théorème de l'échantillonnage de Shannon. Cette période Te peut être égale à un dixième de la période la plus faible des signaux à traiter.

Une telle réalisation présente l'avantage d'une grande simplicité puisque les coefficients du filtre restent inchangés. De plus, il est possible d'avoir des filtres d'ordre quelconque.

**Revendications**

1. Dispositif de filtrage pour atténuer les variations d'un paramètre d'un système appartenant à un véhicule automobile, **caractérisé en ce qu'**il comprend un filtrage non linéaire comprenant au moins un premier élément non linéaire (NL1) disposé en entrée du dispositif et permettant de transformer un signal entrant (e) en une grandeur déterminée par la formule e+K1*NL1(e) où K1 représente un gain, et au moins un second élément non linéaire (NL2) disposé sur une boucle de retour du dispositif, les deux éléments non linéaires (NL1) (10 ; 30), (NL2) (11 ; 31, 31') permettant de faire changer la bande passante du filtre selon que le signal d'entrée augmente ou diminue, le filtre comportant dans les deux cas un filtrage du second ordre basé sur la fonction de transfert H'(s) suivante,

$$H'(s) = \frac{1}{1 + 2\frac{\xi}{\omega_0}s + \frac{s^2}{\omega_0^2}}$$

H'(s) s'écrivant aussi de la façon suivante :

$$H'(s) = \frac{L(s)}{1 + L(s)}$$

avec

$$L(s) = \left(2\frac{\xi}{\omega_0}s + \frac{s^2}{\omega_0^2}\right)^{-1}$$

Soit L(s) réécrit dans la forme suivante :

$$L(s) = K \cdot \frac{1}{s} \cdot \left(\frac{1}{1 + \tau s}\right)$$

avec

$$K = \frac{\omega_0}{2\xi}$$

et

$$\tau = \frac{1}{2\xi\omega_0}$$

2. Dispositif de filtrage selon la revendication précédente, **caractérisé en ce qu'**il comprend deux éléments non linéaires (NL1, NL2), des gains (K1 à K5), deux intégrateurs (12, 13), un dérivateur (14), des additionneurs (15) et des soustracteurs (16), le dispositif comprenant une voie principale (19) sur laquelle sont disposés en aval du premier élément non linéaire (NL1) un additionneur (15), un premier soustracteur (16) sur lequel arrive par une première voie de retour (17) la grandeur définie par la formule y + K5 * NL2(y), un gain (K2), un second soustracteur (16) sur lequel arrive par une seconde voie de retour (18) la grandeur définie par la formule y/G + K4*G'(s)*NL2(y), un gain (K3), deux intégrateurs (12, 13), y représentant la grandeur de sortie du dispositif de filtrage et G la fonction de transfert du second intégrateur (13).

3. Dispositif de filtrage selon la revendication précédente, **caractérisé en ce que** les deux éléments non linéaires se comportent selon le système d'équations suivant :

$$\begin{cases} NL1(x) = NL2(x) = x & si \quad x > 0 \\ NL1(x) = NL2(x) = 0 & si \quad x \le 0 \end{cases}$$

4. Dispositif de filtrage selon la revendication précédente, **caractérisé en ce que** la fréquence de coupure ($\omega_0$) du filtre est modifié d'un facteur A de sorte à prendre une valeur différente (A $\omega_0$) sans changer l'amortissement ($\xi$) entre les configurations de montée ou de descente de la valeur d'entrée (e), en choisissant les paramètres de gain suivants :

$$K1 = A^2 - 1$$

$$K2 = K$$

$$K3 = 1/\tau$$

$$K4 = A - 1$$

$$K5 = A^2 - 1$$

Où

$$K = \frac{\omega_0}{2\xi}$$

et

$$\tau = \frac{1}{2\xi\omega_0}$$

5. Dispositif de filtrage selon la revendication 1, **caractérisé en ce qu'**il comprend une première série d'éléments non linéaires montés en parallèle (NL1,...NLj) en entrée du dispositif, et dont les résultats sont additionnés, et **en ce qu'**il comprend une seconde série d'éléments non linéaires montés en parallèle (NLj+1,...NLn) disposés sur une boucle de retour du dispositif, et dont les résultats sont additionnés, le dispositif modifiant la bande passante du filtrage en fonction du sens de variation du signal d'entrée et en fonction de l'amplitude du signal d'entrée (e) ou de sa dérivée.

6. Dispositif de filtrage selon l'une des revendications précédentes, **caractérisé en ce qu'**il est analogique, comprend des composants électroniques et **en ce que** les au moins deux éléments non linéaires comprennent une diode (56, 62).

7. Dispositif de filtrage selon l'une des revendications 1 à 5, **caractérisé en ce qu'**il est numérique et **en ce que** la variation de la fréquence de coupure du filtre est obtenue par une variation de la fréquence d'échantillonnage.

8. Dispositif d'atténuation des à-coups d'un véhicule automobile **caractérisé en ce qu'**il comprend un dispositif de filtrage selon l'une des revendications précédentes.

9. Véhicule automobile comprenant un dispositif de filtrage selon l'une des revendications 1 à 7.

10. Procédé d'atténuation des à-coups d'un véhicule automobile **caractérisé en ce qu'**il comprend les étapes suivantes :

- détection de l'enfoncement ou du relâchement de la pédale d'accélération ;
- réalisation d'une première correction d'au moins un paramètre de commande du moteur du véhicule automobile lors d'un enfoncement de la pédale d'accélération ;
- réalisation d'une seconde correction du au moins un paramètre de commande du moteur du véhicule automobile lors d'un relâchement de la pédale d'accélération, cette seconde correction étant différente de la première correction,

ces deux corrections étant réalisées par un dispositif de filtrage selon l'une des revendications 1 à 7.

11. Procédé d'atténuation des à-coups d'un véhicule automobile selon la revendication précédente, **caractérisé en ce que** la seconde correction du au moins un paramètre de commande du moteur du véhicule automobile lors d'un relâchement de la pédale d'accélération représente une atténuation plus forte des à-coups que dans le cas de la première correction en situation d'enfoncement de la pédale d'accélération.

12. Procédé d'atténuation des à-coups d'un véhicule automobile selon la revendication 10 ou 11, **caractérisé en ce que** les deux corrections comprennent un filtrage non linéaire d'au moins un paramètre de commande du moteur du véhicule automobile.

13. Procédé d'atténuation des à-coups d'un véhicule automobile selon la revendication 11 ou 12, **caractérisé en ce que** la modification du filtrage entre l'enfoncement et le relâchement de la pédale d'accélération comprend la modification de la fréquence de coupure du filtre sans changer l'amortissement.

14. Procédé d'atténuation des à-coups d'un véhicule automobile selon l'une des revendications 10 à 13, **caractérisé en ce que** le paramètre de commande du moteur corrigé correspond directement ou indirectement à la position de la pédale d'accélération.

**Patentansprüche**

1. Filtervorrichtung zum Verringern der Variationen eines Parameters eines Systems, das zu einem Kraftfahrzeug gehört, **dadurch gekennzeichnet, dass** es ein nicht lineares Filtern mindestens eines ersten nicht linearen Elements (NL1) aufweist, das am Eingang der Vorrichtung angeordnet ist und es erlaubt, ein Eingangssignal (e) in eine Größe umzuwandeln, die durch die Formel e+K1*NL1(e) bestimmt ist, wobei K1 eine Verstärkung darstellt, und mindestens ein zweites nicht lineares Element (NL2), das auf einer Rücklaufschleife der Vorrichtung angeordnet ist, wobei die zwei nicht linearen Elemente (NL1) (10; 30), (NL2) (11; 31, 31') es erlauben, den Durchlassbereich des Filters je nachdem zu verändern, ob das Eingangssignal zu-oder abnimmt, wobei das Filter in beiden Fällen eine Filterung des zweiten Rangs aufweist, die auf der folgenden Transferfunktion H'(s) beruht,

$$H'(s) = \frac{1}{1 + 2\frac{\xi}{\omega_0}s + \frac{s^2}{\omega_0^2}}$$

wobei H'(s) wie folgt geschrieben wird:

$$H'(s) = \frac{L(s)}{1 + L(s)}$$

mit

$$L(s) = \left(2\frac{\xi}{\omega_0}s + \frac{s^2}{\omega_0^2}\right)^{-1}$$

das heißt, L(s) in der folgenden Form umgeschrieben:

$$L(s) = K \cdot \frac{1}{s} \cdot \left(\frac{1}{1 + \tau s}\right)$$

mit

$$K = \frac{\omega_0}{2\xi}$$

und

$$\tau = \frac{1}{2\xi\omega_0}$$

2. Filtervorrichtung nach dem vorhergehenden Anspruch, **dadurch gekennzeichnet, dass** sie zwei nicht lineare Elemente (NL1, NL2), Verstärkungen (K1 bis K5), zwei Integratoren (12, 13), einen Differenziator (14), Addierer (15) und Subtrahierer (16) aufweist, wobei die Vorrichtung einen Hauptkanal (19) aufweist, auf dem, stromabwärts des ersten nicht linearen Elements (NL1), ein Addierer (15), ein erster Subtrahierer (16), auf dem über einen ersten Rücklaufkanal (17) die Größe ankommt, die von der Formel y + K5 * NL2(y) definiert ist, eine Verstärkung (K2), ein zweiter Subtrahierer (16), auf dem über einen zweiten Rücklaufkanal (18) die Größe ankommt, die von der Formel y/G + K4*G'(s)*NL2(y) definiert ist, eine Verstärkung (K3) und zwei Integratoren (12, 13) angeordnet sind, wobei y die Ausgangsgröße der Filtervorrichtung darstellt, und G die Transferfunktion des zweiten Integrators (13).

3. Filtervorrichtung nach dem vorhergehenden Anspruch, **dadurch gekennzeichnet, dass** sich die zwei nicht linearen Elemente gemäß dem folgenden Gleichungssystem verhalten:

$$\begin{cases} NL1(x) = NL2(x) = x, \text{ wenn } x > 0 \\ NL1(x) = NL2(x) = 0, \text{ wenn } x \leq 0 \end{cases}$$

4. Filtervorrichtung nach dem vorhergehenden Anspruch, **dadurch gekennzeichnet, dass** die Grenzfrequenz ($\omega_0$) des Filters um einen Faktor A derart geändert wird, dass sie einen unterschiedlichen Wert (A $\omega_0$) annimmt, ohne die Dämpfung ($\xi$) zwischen den Anstiegs- oder Abstiegskonfigurationen des Eingangswerts (e) zu ändern, indem die folgenden Verstärkungsparameter ausgewählt werden:

$$K1 = A^2 - 1$$

$$K2 = K$$

$$K3 = 1/\tau$$

$$K4 = A - 1$$

$$K5 = A^2 - 1$$

wobei

$$K = \frac{\omega_0}{2\xi}$$

und

$$\tau = \frac{1}{2\xi\omega_0}$$

5. Filtervorrichtung nach Anspruch 1, **dadurch gekennzeichnet, dass** sie eine erste Reihe nicht linearer Elemente (NL1,... NLj) aufweist, die parallel am Eingang der Vorrichtung geschaltet sind, und deren Resultate summiert werden, und dass sie eine zweite Reihe nicht linearer Elemente parallel geschalteter (NLj+1,... NLn) aufweist, die in einer Rücklaufschleife der Vorrichtung angeordnet sind, und deren Resultate summiert werden, wobei die Vorrichtung den Durchlassbereich der Filterung in Abhängigkeit von der Richtung der Variation des Eingangssignals und in Abhängigkeit von der Amplitude des Eingangssignals (e) oder seiner Drift ändert.

6. Filtervorrichtung nach einem der vorhergehenden Ansprüche, **dadurch gekennzeichnet, dass** sie analog ist, elektronische Bauteile aufweist, und dass die mindestens zwei nicht linearen Elemente eine Diode (56, 62) aufweisen.

7. Filtervorrichtung nach einem der Ansprüche 1 bis 5, **dadurch gekennzeichnet, dass** sie digital ist, und dass die Variation der Grenzfrequenz des Filters durch eine Variation der Abtastfrequenz erzielt wird.

8. Vorrichtung zum Dämpfen der Ruckbewegungen eines Kraftfahrzeugs, **dadurch gekennzeichnet, dass** sie eine Filtervorrichtung nach einem der vorhergehenden Ansprüche aufweist.

9. Kraftfahrzeug, das eine Filtervorrichtung nach einem der Ansprüche 1 bis 7 aufweist.

10. Vorrichtung zum Dämpfen der Ruckbewegungen eines Kraftfahrzeugs, **dadurch gekennzeichnet, dass** sie die folgenden Schritte aufweist:

   - Erfassen des Hineindrückens oder des Freigebens des Gaspedals,
   - Ausführen einer ersten Korrektur mindestens eines Steuerparameters des Motors des Kraftfahrzeugs bei einem Hineindrücken des Gaspedals,
   - Ausführen einer zweiten Korrektur des mindestens einen Steuerparameters des Motors des Kraftfahrzeugs bei einem Freigeben des Gaspedals, wobei diese zweite Korrektur von der ersten Korrektur unterschiedlich ist,

   wobei diese zwei Korrekturen von einer Filtervorrichtung nach einem der Ansprüche 1 bis 7 ausgeführt werden.

11. Verfahren zum Dämpfen der Ruckbewegungen eines Kraftfahrzeugs nach dem vorhergehenden Anspruch, **dadurch gekennzeichnet, dass** die zweite Korrektur des mindestens einen Steuerparameters des Motors des Kraftfahrzeugs bei einem Freigeben des Gaspedals eine stärkere Dämpfung der Ruckbewegungen aufweist als in dem Fall der ersten Korrektur in der Situation des Hineindrückens des Gaspedals.

12. Verfahren zum Dämpfen der Ruckbewegungen eines Kraftfahrzeugs nach dem Anspruch 10 oder 11, **dadurch gekennzeichnet, dass** die zwei Korrekturen ein nicht lineares Filtern mindestens eines Steuerparameters des Motors des Kraftfahrzeugs aufweisen.

13. Verfahren zum Dämpfen der Ruckbewegungen eines Kraftfahrzeugs nach Anspruch 11 oder 12, **dadurch gekennzeichnet, dass** die Änderung des Filterns zwischen dem Hineindrücken und dem Freigeben des Gaspedals das Ändern der Grenzfrequenz des Filters ohne Änderung der Dämpfung aufweist.

14. Verfahren zum Dämpfen der Ruckbewegungen eines Kraftfahrzeugs nach einem der Ansprüche 10 bis 13, **dadurch gekennzeichnet, dass** der korrigierte Steuerparameter des Motors direkt oder indirekt der Position des Gaspedals entspricht.

## Claims

1. Filtering device for reducing fluctuations in a parameter of a system belonging to a motor vehicle, **characterized in that** it comprises a non-linear filter comprising at least a first non-linear element (NL1) arranged at the input of the device and making it possible to transform an input signal (e) into a quantity determined by the formula e+K0*NL1(e) where K1 represents a gain, and at least a second non-linear element (NL2) arranged on a return loop of the device, the two non-linear elements (NL1) (10;30), (NL2) (11; 31, 31') making it possible to make the passband of the filter change according to whether the input signal increases or decreases, the filter including in both cases a second-order filtering based on the following transfer function H'(s),

$$H'(s) = \frac{1}{1 + 2\frac{\xi}{\omega_0}s + \frac{s^2}{\omega_0^2}}$$

H'(s) also being written in the following manner:

$$H'(s) = \frac{L(s)}{1 + L(s)}$$

with

$$L(s) = \left(2\frac{\xi}{\omega_0}s + \frac{s^2}{\omega_0^2}\right)^{-1}$$

Let L(s) be re-written in the following form:

$$L(s) = K \cdot \frac{1}{s} \cdot \left(\frac{1}{1+\tau s}\right)$$

with

$$K = \frac{\omega_0}{2\xi}$$

and

$$\tau = \frac{1}{2\xi\omega_0}$$

2. Filtering device according to the preceding claim, **characterized in that** it comprises two non-linear elements (NL1, NL2), gains (K1 to K5), two integrators (12, 13), a differentiator (14), adders (15) and subtractors (16), the device comprising a main path (19) on which are arranged downstream of the first non-linear element (NL1) an adder (15), a first subtractor (16) on which the quantity defined by the formula y+ K5*NL2(y) arrives by a first return path (17), a gain (K2), a second subtractor (16) on which the quantity defined by the formula y/G + K4*G'(s)*NL2(y) arrives by a second return path (18), a gain (K3), two integrators (12, 13), y representing the output quantity of the filtering device and G the transfer function of the second integrator (13).

3. Filtering device according to the preceding claim, **characterized in that** the two non-linear elements behave according to the following system of equations:

$$\begin{cases} NL1(x) = NL2(x) = x & \text{if} \quad x > 0 \\ NL1(x) = NL2(x) = 0 & \text{if} \quad x \leq 0 \end{cases}$$

4. Filtering device according to the preceding claim, **characterized in that** the cut-off frequency ($\omega_0$) of the filter is modified by a factor A so as to take a different value (A $\omega_0$) without changing the damping ($\xi$) between the upward or downward configurations of the input value (e), by choosing the following gain parameters:

$$K1 = A^2 - 1$$

$$K2 = K$$

$$K3 = 1/\tau$$

$$K4 = A-1$$

$$K5 = A^2-1$$

Where

$$K = \frac{\omega_0}{2\xi}$$

and

$$\tau = \frac{1}{2\xi\omega_0}$$

5. Filtering device according to Claim 1, **characterized in that** it comprises a first series of non-linear elements assembled in parallel (NL1,...NLj) at the input of the device, and the results of which are added, and **in that** it comprises a second series of non-linear elements assembled in parallel (NLj+1,...NLn) arranged on a return loop of the device, and the results of which are added, the device modifying the passband of the filter as a function of the direction of fluctuation of the input signal and as a function of the amplitude of the input signal (e) or of its derivative.

6. Filtering device according to one of the preceding claims, **characterized in that** it is analogue, comprises electronic components and **in that** the at least two non-linear elements comprise a diode (56, 62).

7. Filtering device according to one of Claims 1 to 5, **characterized in that** it is digital and **in that** the fluctuation of the cut-off frequency of the filter is obtained by a fluctuation of the sampling frequency.

8. Device for reducing jolts in a motor vehicle, **characterized in that** it comprises a filtering device according to one of the preceding claims.

9. Motor vehicle comprising a filtering device according to one of Claims 1 to 7.

10. Method for reducing jolts in a motor vehicle, **characterized in that** it comprises the following steps:

    - detecting the depression or release of the accelerator pedal;
    - performing a first correction of at least one control parameter of the engine of the motor vehicle upon depression of the accelerator pedal;
    - performing a second correction of the at least one control parameter of the engine of the motor vehicle upon release of the accelerator pedal, this second correction being different from the first correction,

    these two corrections being performed by a filtering device according to one of Claims 1 to 7.

11. Method for reducing jolts in a motor vehicle according to the preceding claim, **characterized in that** the second correction of the at least one control parameter of the engine of the motor vehicle upon release of the accelerator pedal represents a larger reduction of the jolts than in the case of the first correction in a situation of depression of the accelerator pedal.

12. Method for reducing jolts in a motor vehicle according to Claim 10 or 11, **characterized in that** both corrections comprise a non-linear filtering of at least one control parameter of the engine of the motor vehicle.

13. Method for reducing jolts in a motor vehicle according to Claim 11 or 12, **characterized in that** the modification of the filtering between the depression and the release of the accelerator pedal comprises the modification of the cut-off frequency of the filter without changing the damping.

**14.** Method for reducing jolts in a motor vehicle according to one of Claims 10 to 13, **characterized in that** the control parameter of the corrected engine corresponds directly or indirectly to the position of the accelerator pedal.

# Fig.1

# Fig.2

# Fig.3

# Fig.4

# Fig.5

# Fig.6

# Fig.7

# Fig.8

# Fig.9

# Fig.10

# Fig.11

# Fig.12

# Fig.13

EP 2 149 987 B1

Fig.14

Step response

25